# EUROPEAN PATENT APPLICATION

(11) **EP 0 751 577 A2**
(43) Date of publication of application: **02.01.1997**
(21) Application number: 96870087.2
(22) Date of filing: 28.06.1996
(51) Int. Cl.: H01L 31/108, H01L 31/18

(54) **Method for the formation of thin PtSi layers on a Si substrate**

(30) Priority: 28.06.1995 US 580
(71) Applicant: INTERUNIVERSITAIR MICRO-ELEKTRONICA CENTRUM VZW, B-3001 Heverlee (BE)
(72) Inventor: Kolodinski, Sabine, 38543 Hillerse (DE); Torres, Alfonso, Puebla, Pue 72000 (MX); Donaton, Ricardo Alves, 3001 Heverlee (BE)
(74) Representative: Van Malderen, Joelle

(57) **Abstract**

A method for forming continuous thin PtSi layers on a silicon substrate comprising the steps of:
- depositing under high vacuum conditions a Pt layer on said substrate;
- heating thereafter said substrate at a first temperature for a first time period whereby performing a first heating step;
- removing unreacted Pt and Pt-rich silicide phases;
- heating said substrate at a second temperature, higher than the first temperature, for a second time period whereby performing a second heating step.

## Description

### Field of the invention

The present invention is related to a method for the formation of thin PtSi layers on a Si substrate. The present invention is also related to the use of said method for the fabrication of infrared detectors.

### Background of the invention

Metal based silicides on silicon substrates are widely used for infrared detection applications. The detection mechanism in these silicide/silicon Schottky barrier detectors is the internal photoemission method. The main advantage of this type of detectors in the ease of integration in very large scale integration (VLSI)-processes which allows for very large two dimensional detector arrays. Despite their low quantum efficiency compared to photovoltaic detectors, PtSi/p-type Si infrared Schottky barrier detectors (IRSBD) have become one of the most successful photoemissive infrared detector materials. Based on the photoemission theory and experimental studies, the lower the barrier height of the Schottky barrier diodes, the higher are the electrical yield and the leakage current. Besides, PtSi can be formed in a self-aligned way. This means that during thermal treatment the platinum metal reacts with silicon but not with silicon oxide, and an alignment of the silicide with the window edges of the oxide regions present on the silicon wafer is achieved. The unreacted metal is removed by a selective wet etch. Parameters like silicide thickness, Schottky barrier height and optical yield are process dependent. The minimum film thickness is only limited by the fabrication technology. For good detection behavior the silicide layer has to be thin, with thickness in the range of 2 to 8 nm. Therefore, control of the uniformity and thickness of the silicide layer is critical. Incoherent and non-uniform films in the form of islands are resulting when the thickness of the silicide is reduced below a thickness of 2 nm as disclosed by W.A. Cabanski and M.J. Schulz in the reference "Electronic and IR-Optical Properties of Silicide/Silicon Interfaces", Infrared Phys. Vol. 32, pp. 29-44, 1991.

The conventional method of formation of a thin silicide comprises the deposition of a thin layer of metal, followed by a heating step. The controllability of the metal thickness during deposition of very thin layers is an important issue in this process. Therefore, thin PtSi films are usually fabricated by e-beam evaporation of Pt on a substrate in an Ultra High Vacuum apparatus. A subsequent furnace heating at temperatures of 450-550°C for 30 minutes is used to form silicide. This process is followed by a selective etch to remove unreacted Pt.

A specific technique for the formation of thin Pt silicide films is by e-beam deposition of a Pt layer of half the thickness of the desired PtSi layer, in ultra high vacuum conditions. Then an annealing in inert environment is performed to obtain the metal silicide. For IRSBD applications, the required thicknesses are in the 2-10 nm range , hence the required metal layer is to be as thin as 4 monolayers. If the deposited metal is not uniform, the possibility of resulting in a non-uniform PtSi layer is very high leading to non-uniformity in two dimensional (2-D) IRSBD arrays.

The process techniques as disclosed in the prior art are expensive as they require Ultra High Vacuum apparatuses.

### Aim of the present invention

It is the aim of the present invention to disclose a two-step rapid thermal processing (RTP) method to form continuous ultra-thin PtSi layer with a thickness as low as possible and preferably less than 10 nm on a Si substrate.

### Summary of invention

The present invention is related to a two-step rapid thermal processing (RTP) method in order to form continuous ultra-thin PtSi layer with a thickness as thin as 2 nm. Other thickness smaller than 10 nm, for instance, 6 nm are also feasible as well.

This method can be performed in standard High Vacuum Sputter Deposition equipment which is less expensive and more compatible with standard VLSI processing than Ultra-High Vacuum equipment. This method is independent of the deposited Pt thickness and results in a smaller grain size than that obtained by conventional furnace annealing. Furthermore, little roughness is observed at the silicide-Si interface.

The advantages of this technique are the use of sputtering for metal deposition which is more compatible with standard silicon processing technologies, the deposition of a thick layer of metal and the use of the rapid thermal processing. Rapid Thermal Processing introduces lower contamination levels and yields short processing times.

It is proposed to have a method based on a two-step rapid thermal processing (RTP) to form ultra-thin PtSi layers.

More particularly, the present invention is related to a method which comprises the steps of:
- depositing under high vacuum conditions a Pt layer on a Si substrate;
- heating said substrate at a first temperature for a first time period whereby performing a first heating step;
- removing and more particularly etching the unreacted Pt and Pt-rich silicide phases;
- heating said substrate at a second temperature higher than the first temperature for a second time period whereby performing a second heating step.

The expression "said substrate" is meant to be the last product obtained by the former step.

Preferably the heating steps are done in a Rapid Thermal Processing device, wherein said first time period is shorter than 60 seconds, and said second time period is comprised between 45 and 120 seconds.

According to one preferred embodiment, said first temperature is smaller than 300°C and preferably about 200°C and said second temperature is between the range of 400°C-600°C and preferably about 450°C.

More preferably, the deposition step of the Pt layer is performed in a high vacuum sputter deposition apparatus.

This method can be used for forming a PtSi layer having a controlled thickness preferably less than 8 nm and in particular around 2 nm.

According to another preferred embodiment, said method can be used in order to form PtSi/Si infrared Schottky barrier detectors.

### Brief descriptions of the drawings

Figure 1 shows the thickness of the PtSi layer obtained according to a two-step RTP method according to the present invention.

Figure 2 represents a high resolution TEM picture of a PtSi layer obtained according to the two-step RTP method of the present invention.

Figure 3 shows the cross-sectional TEM picture of PtSi layer obtained by the two-step RTP method according to the present invention.

Figures 4 show graphs of measured PtSi/Si diodes obtained using the two-step RTP method according to the present invention.

### Detailed description of the present invention

During the development of the method according to the present invention, a set of experimental conditions was chosen. It is obvious that any other process conditions can be chosen yielding the same results.

P-type Si wafers (100) orientation, 25-35 Ω-cm and B-doped are used. Prior to Pt deposition, the wafers are cleaned using the standard RCA cleaning. Immediately before transferring the wafers into the vacuum chamber, they are etched in a HF solution to remove the surface oxide. The Pt deposition is performed at a base pressure of 4x10⁻⁶ mbar. Continuous Ar purging while reaching the base pressure is used in order to minimize the oxygen partial pressure. Pt layers with thickness ranging in between 30-75 nm are sputtered. Silicidation is done by a two-step RTP process. Experiments were performed with the first RTP temperature at 200, 225 or 250 and 300°C. The RTP time is varied from 5 to 60 seconds. N₂ was used as the RTP ambient in all cases. Other inert gases can be used as well. The un-reacted Pt is removed using a solution consisting of 800 ml. Acetic Acid: 460 ml, HCl: 60 ml, HNO₃ heated at 85°C. The second RTP process step is carried out at 400-600°C, preferably 450°C for typically about one minute in N₂ or another inert gas. Sheet resistance, x-ray diffraction and transmission electron microscopy (TEM) are used to examine the obtained films.

The results show that it is possible to form continuous ultra-thin PtSi layers (thickness from 2 to 6 nm) with the two-step RTP process. The reaction sequence can be summarized as follows:
- a thick sputtered Pt layer is formed first;
- after the first RTP step, a multi-phase structure consisting of Pt/Pt₂Si/PtSi: Si is formed;
- after selective etch, only PtSi/Si remains, the PtSi having very small grains;
- after the second RTP step, the structure is PtSi/Si, with PtSi having larger grains.

The homogeneity of the resulting PtSi-layers is not dependent on the homogeneity of Pt-deposition directly, but only on the homogeneity of temperature distribution on the wafer during the first RTP step. A Pt-layer deposited by any deposition technique can, in principle, be used to obtain uniform and pin-hole free PtSi-layers by this silicidation technique. The first RTP temperatures are determined to cover the required range for IRSBD application. For the application of two-dimensional IRSBD, a sputtering deposition was used, because a good step coverage is achieved and a full coverage of the active detector area is possible.

The thickness of the resulting silicide is supposed to be controlled by the first RTP step and is independent of the initial metal thickness.

A possible explanation of the results might be as follows:

The two-step process follows the phase growth sequence of the silicidation of Pt to PtSi via Pt₂Si. Since near noble metals react with Si to form the metal rich phase at temperatures between 100-200°C, the first heating step is performed at a low temperature to initiate the formation of a metal-rich silicide phase. The formed silicide may consist of Pt₂Si-phase only, since it might be that PtSi-formation only begins after all available Pt has reacted to Pt₂Si. The time of silicidation is chosen such that only a thin layer of Pt can react with the Si underneath, whereas most of the deposited, unreacted Pt is removed. In the second heating step, the transformation of the Pt₂Si into PtSi is carried out at a higher temperature. The final thickness of the PtSi layer is dependent on the thickness of the initial Pt₂Si- layer thickness which is controlled by the time of the first anneal. It is not dependent on the thickness of the deposited Pt-layer which is much thicker than the resulting PtSi-layers.

Though it is a plausible explanation of the observed phenomena, a detailed x-ray diffraction (XRD) analysis and Transmission Electron Microscopy (TEM) measurements show the results described in the sequel:

The XRD measurements are performed under different grazing incidence angles yielding information from different depths in the sample that is investigated.

At an incidence angle of 0.5° (i.e. below the critical angle), a sample with a thick sputtered Pt layer shows after the first step RTP heating only a single Pt peak: the (220)_{Pt} reflection. Under these conditions, the information is due to the upper 5 nm of the layers. By increasing the incidence angle to 2°, except of the (220)_{Pt}, also a large number of peaks due to Pt₂Si are found. Their relative intensities indicate the absence of texture in the Pt₂Si. Additional measurement with a symmetric set-up indicates a (111) texture in the Pt layer.

After the etch, no diffraction peaks related to the Pt layer are found for the measurements at 0.5-3° incidence. This indicates that the layer is much thinner than before so that the signal becomes too weak, or that the layer has unfavorable texture so that at this incidence angle, no planes are diffracting.

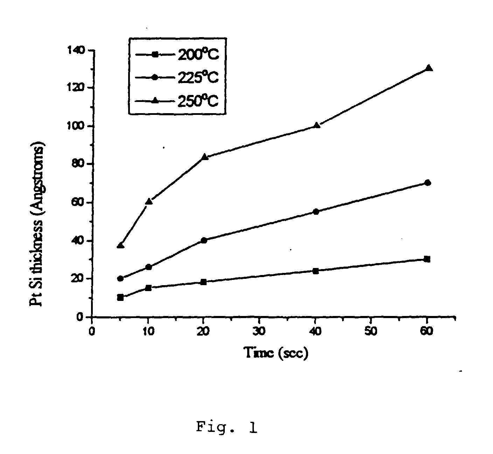

The XRD measurement at 2° incidence shows two peaks after the second heating (fig. 1c). These can be assigned to PtSi: (020)_{PtSi} and (121)_{PtSi}. The absence of other peaks of that phase can indicate the presence of texture in the layer.

Transmission electron microscopy (TEM) is used for further characterization of the micro-structure of the layer, the layer thickness uniformity and roughness. Plan view samples of a Pt sputtered sample after the first heating show a grain size of 25-40 nm. In the thinnest specimen regions, i.e. the upper part of the layers continuous electron diffraction rings due to Pt are observed. In agreement with the (111) texture observed by XRD, the main ring due to the Pt is (220)_{Pt}. In the thicker specimen regions which include also the lower part of the layer, additional rings due to Pt₂Si are found. Their relative intensities indicate the absence of texture in the layer. The two layer structure Pt/Pt₂Si is also observed on cross-sectional samples which shows a ~50 nm Pt and ~25 nm Pt₂Si layer. The silicide/silicon interface show some undulations so that the possible presence of a thin intermediate layer is difficult to distinguish. After the step etch, a very fine granular structure is observed in plan-view samples with grains of 4-5 nm. Also larger grains with sizes on the order of 10-50 nm are present. The electron diffraction pattern shows continuous rings due to PtSi. Although a small Pt₂Si content in the layer will be difficult to recognize due to the overlapping diffraction rings, it can be concluded that there is no indication for the presence of Pt₂Si. This means that the PtSi is already formed during the first low temperature RTP step and that the etch solution has removed both the Pt and Pt₂Si. After the second RTP heating step, the grains size is more uniform and larger (20-40 nm).

Cross-sectional TEM shows that depending on the processing conditions of the first RTP step, PtSi layers with thicknesses down to 2 nm can be formed by the two-step RTP method.

It is shown that by a two-step RTP method, uniform and continuous ultra-thin (2-6 nm) PtSi layers can be formed. Combining the results of the grazing incidence XRD with the plan-view and cross-sectional TEM, a detailed insight of the different phases formed during the two RTP steps is obtained.

For the method starting from a thick sputtered Pt layer, the reaction scheme is:
- formation of a multi-phase structure Pt/Pt₂Si/PtSi/Si during the first anneal. The Pt is (111) textured, while the Pt₂Si shows no texture.
- after the etch, only the PtSi remains, i.e., the structure is PtSi/Si with very small grains. Some (110) texture is present but the grains are mainly randomly oriented.
- after the second RTP, the structure is PtSi/Si with larger grains and equal partial texture.

The thickness of the final PtSi is controlled by the conditions of the first RTP and does not depend on the thickness of the sputtered Pt.

Samples prepared with our e-beam deposited Pt layer for comparison show:
- after the first RTP and after the etch, a mixture of an unknown silicide phase with epitaxial (110)-textured PtSi.
- after the second RTP, mainly epitaxial(110)-textured PtSi is present. In this case, the PtSi thickness is mainly controlled by the deposition conditions.

Figure 1 shows the thickness of the PtSi obtained by the above described method after the complete silicidation cycle with varying first RTP process temperatures. The thicknesses in figure 1 are inferred from sheet resistance (Rs) measurements. As a calibration 3 samples with different thicknesses that are measured by means of TEM and are used to obtain the average resistivity. In our case, the average resistivity resulted in a value of 54.4 µΩ-cm. This value is about 1.6 times the known value for thicker PtSi films.

The sheet resistance uniformity over the wafer is very good even for the thinner films (∼ 1-2 nm). The measured Rs for these thicknesses are much lower than the ones measured for discontinuous films indicating that our films are continuous. Whereas conventional furnace heating is restricted in thickness to silicidations of at least 1.5 nm of Pt (resulting in about 3 nm of PtSi) for the reason of achieving continuous films, our method allows for making continuous PtSi-layers as thin as 2 up to 2.5 nm.

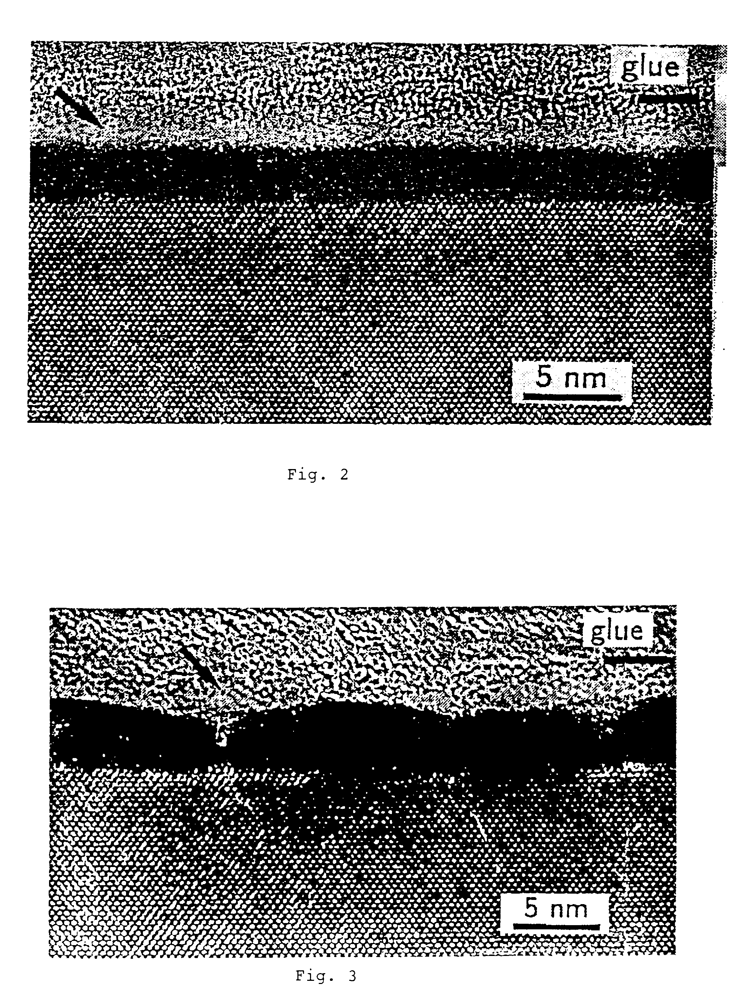

Figures 2 and 3 give cross-sectional high resolution transmission electron microscopy (TEM) pictures of thin PtSi layers on silicon (100)-substrates which are achieved by the described two-step RTP silicidation method. Figure 3 shows a PtSi-layer for which the first RTP heating step was at 200°C for 5 seconds. The samples for figure 3 was heated at the same temperature for 60 seconds. In all the pictures, the typical lattice structure of the Si-substrate is seen at the bottom of the picture. The very dark part on top of this layer corresponds to the metallic PtSi-layer. Next to this PtSi-layer, a thin amorphous layer of about the same thickness as the silicide is seen, followed by the glue on the very top which is due to the preparation of the samples for TEM.

Figures 2 and 3 show very homogeneous and uniform silicide layers of 2.5 nm and 3.6 nm thicknesses. The PtSi/Si-interfaces in both pictures are extraordinarily smooth.

In case of figure 2, the interface undulation is only in the order of 10% of the silicide thickness. This improved value is most probably due to the low temperature cycles in RTP processes.

Apart from Si-lattice, some lattice imaging can also be seen in the silicide layer. The planes which can be observed along the arrows on fig. 2 and fig. 3 have a lattice spacing of 0.268 nm and 0.271 nm respectively. Both values coincide within experimental error with the spacing of the (111)-planes which are 0.2698 of the orthorhombic PtSi.

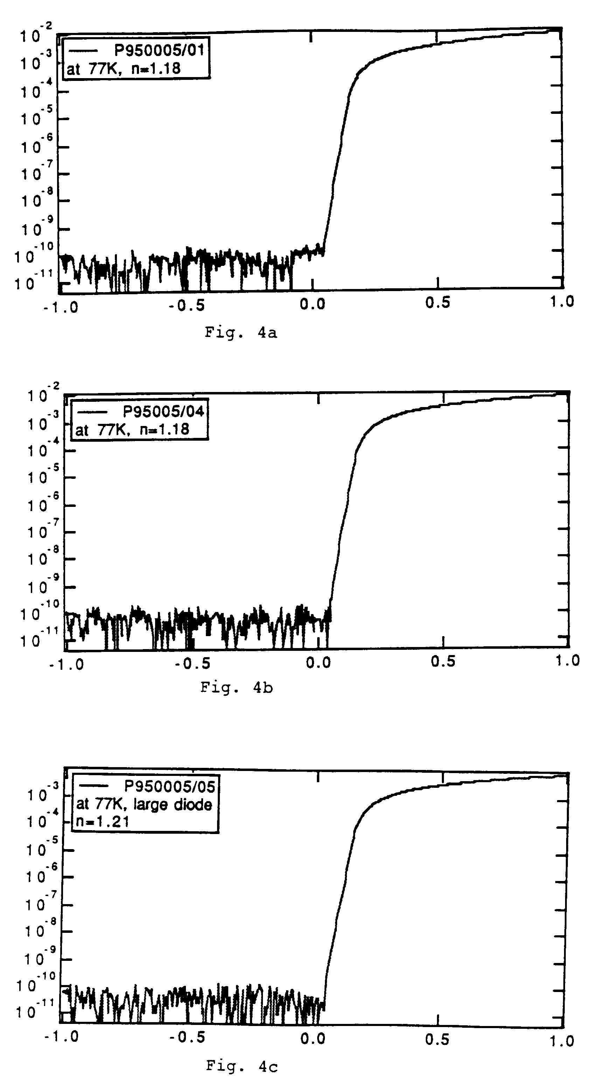

Figures 4 show I-IV measurements in liquid nitrogen on the PtSi/Si structures after processing.

Silicidation conditions are:
- Pt deposition: 30 nm
- 1st RTP step:

| | | |
|---|---|---|
| 200°C, 60 sec. | P950005/01,02 | all |
| 250°C, 60 sec. | P950005/04,05 | all |

- 2nd RTP step: 450°C, 60 sec.

The references P950005/01,02,04,05 refer to the process modules.

I-V measurements have been performed with the aid of HP 4134 parameter analyzer in liquid nitrogen at temperature 77K. Ideality factors for diodes with the PtSi area 300 µm x 600 µm are summarized in the Table 1. These results confirm that with the RTP process according to the present invention, a good interface quality is obtained.

**Table 1.**

| PtSi diodes ideality factor | |
|---|---|
| P950005/01 | n = 1.18 |
| P950005/02 | n = 1.17 |
| P950005/04 | n = 1.18 |
| P950005/05> | n = 1.21 |

## Claims

1. A method for forming continuous thin PtSi layers on a silicon substrate comprising the steps of:
- depositing under high vacuum conditions a Pt layer on said substrate;
- heating thereafter said substrate at a first temperature for a first time period whereby performing a first heating step;
- removing unreacted Pt and Pt-rich silicide phases;
- heating said substrate at a second temperature, higher than the first temperature, for a second time period whereby performing a second heating step.

2. A method as recited in claim 1, wherein said heating steps are done in a Rapid Thermal Processing device, said first time period being shorter than 60 seconds, and said second time period comprised between 45 and 120 seconds.

3. A method as recited in claim 2, wherein said first temperature is smaller than 300°C and said second temperature is in the range of 400°C-600°C.

4. A method as recited in claim 3, wherein said first temperature is about 200°C and said second temperature is about of 450°C.

5. A method as recited in claim 4, wherein said deposition step of the Pt layer is performed in a high vacuum sputter deposition apparatus.

6. Use of the method as recited in any one of the preceding claims for forming a PtSi layer having a controlled thickness on a silicon substrate.

7. Use of the method according to claim 6, wherein the thickness of the PtSi layer is smaller than 8 nm.

8. Use of the method according to claim 7, wherein the thickness of the PtSi layer is 2 nm.

9. Use of the method as recited in any one of the claims 1 to 5, in order to form PtSi/Si infrared Schottky barrier detectors.
